# EUROPÄISCHE PATENTSCHRIFT

(11) **EP 0 696 817 B1**
(45) Veröffentlichungstag und Bekanntmachung des Hinweises auf die Patenterteilung: **12.07.2000**
(21) Anmeldenummer: 94118699.1
(22) Anmeldetag: 28.11.1994
(51) Int. Cl.: H01L 21/00

(54) **Einrichtung zur Kopplung von Be- und Entladegeräten mit Halbleiterbearbeitungsmaschinen**
Device for coupling loading and unloading apparatus to semiconductor treatment machines
Dispositif pour le couplage d'appareils de chargement et de déchargement aux machines de traitement de semi-conducteurs

(30) Priorität: 16.07.1994 DE 4425208
(43) Veröffentlichungstag der Anmeldung: 14.02.1996
(73) Patentinhaber: JENOPTIK Technologie GmbH, D-07745 Jena (DE)
(72) Erfinder: Scheler, Werner, D-07743 Jena (DE); Lahne, Berndt, D-07747 Jena (DE); Mages, Andreas, D-07745 Jena (DE); Michl, Uwe, D-07747 Jena (DE); Gemkow, Eberhard, D-07747 Jena (DE); Schulz, Alfred, D-07747 Jena (DE)
(74) Vertreter: Geyer, Werner, Dr.-Ing.

(56) Entgegenhaltungen:
- EP-A- 0 273 791
- EP-A- 0 335 752
- FR-A- 2 696 429

## Beschreibung

Die Erfindung betrifft eine Einrichtung zur Kopplung von Be- und Entladegeräten mit Halbleiterbearbeitungsmaschine, mit der eine Nachrüstung derartiger Maschinen mit der SMIF-Technologie unter Beachtung ergonomischer Erfordernisse ermöglicht wird.

Bei der Herstellung integrierter Schaltkreise müssen Halbleiterscheiben zwischen unterschiedlichen Bearbeitungsschritten zu einzelnen Bearbeitungsmaschinen transportiert werden. In zunehmendem Maße geschieht dies in standardisierten Transportbehältern, sogenannten Standard Mechanical Interface Boxen (SMIF-Boxen), da anstelle der Optimierung konventioneller Reinräume in Richtung höherer Reinheitsklassen zur Erzielung größerer Integrationsdichten eine konsequente Durchsetzung des Einsatzes von Einhausungen oder der Einsatz der SMIF-Technologie in den Halbleiterbearbeitungsmaschinen einen Weg darstellt, um höhere Ausbeuten zu vertretbaren Kosten zu erreichen.
Auf dem Boden der SMIF-Boxen, die ein relativ Kleines abgeschlossenes Volumen aufweisen, ist das Magazin, in dessen Fächern sich die Halbleiterscheiben befinden, in geeigneter Weise fixiert.
Zur Beschickung der Bearbeitungsmaschinen werden die Magazine aus den Transportbehältern z. B. mit einer Be- und Entladeeinrichtung gemaß der DE-Patentschritt 43 26 309 C1 oder einer Einrichtung, mit anderen Funktionsablauf entladen und in der Bearbeitungsmaschine plaziert. Nach der Bearbeitung der Halbleiterscheiben erfolgt der Rücktransport der Magazine in die Transportbehälter. Da sich die räumliche Anordnung der Be- und Entladeeinrichtungen üblicherweise nach dem Bearbeitungszyklus in der Maschine richtet, wird deren Bestückung mit Magazinen oder Magazinen im Transportbehälter und damit die manuelle Beschickung der Bearbeitungsmaschinen bei zunehmender Größe der Halbleiterscheiben zum Problem.
Besondere Schwierigkeiten treten auf, wenn Maschinen der Halbleiterfertigung mit der SMIF-Technologie nachgerüstet werden sollen, da eine nachträgliche bauliche Integration in den seltensten Fällen möglich ist.

Aus FR-A-2 696 429 ist eine Einrichtung gemäß dem Oberbegriff des Anspruchs 1 der vorliegenden Anmeldung. Außerdem wird eine Einrichtung zur Kopplung eine Be- und Entladeeinrichtung mit einer Halbleiterbearbeitungsmaschine offenbart.

Aufgabe der Erfindung ist es deshalb, Geräte, die zur Anwendung der SMIF-Technologie erforderlich sind, mit Halbleiterbearbeitungsmaschinen zu koppeln, in die eine nachträgliche Integration der SMIF-Technik ausgeschlossen ist, wobei die nach der Kopplung erforderliche Beschickung eine hohe Flexibilität aufweisen und einer zunehmenden Größe der Halbleiterscheiben gerecht werden soll.

Die Aufgabe wird durch eine Einrichtung zur Kopplung von Be- und Entladegeräten mit Halbleiterbearbeitungsmaschinen gemäß Anspruch 1 gelöst.

Das Aufnahmeelement kann entweder eine mit einem Lift verbundene justierbare Platte sein oder die justierbare Platte wird von einem auf dem Lift befestigten horizontal beweglichen Element getragen.

Der Vorteil eines horizontal verschiebbaren Aufnahmeelementes besteht darin, daß mit einer einzigen Be- und Entladeeinrichtung alle Bearbeitungsplätze einer Halbleiterbearbeitungsmaschine versorgt werden können. Es wird kein Standplatz für weitere Beladeeinrichtungen benötigt.

Damit die Einhausung, mit der ein Mini-Reinstraum realisiert, der eine horizontale turbulenzarme Luftströmung (Erstluft) durch die Magazine in jeder Phase der Beschickung der Halbleiterbearbeitungsmaschine unter Berücksichtigung der verschiedenen Beschickungssmethoden gewährleistet, besteht diese
aus einem feststehenden äußeren Teil und einem ausfahrbaren inneren Teil, der das Aufnahmeelement zusammen mit der Be- und Entladeeinrichtung umschließt. Zur Verstellung des Aufnahmeelementes zwischen den übereinanderliegenden Ebenen ist der innere Teil zusammen mit dem Aufnahmeelement und der Be- und Entladeeinrichtung teleskopartig aus- und einfahrbar.

Vorteilhafterweise ist am ausfahrbaren inneren Teil Einhausung mindestens ein Verschlußelement vorgesehen zum Verschließen von Beschickungsöffnungen in der Halbleiterbearbeitungsmaschine.
Beide Teile der Einhausung weisen zur Gewährleistung des Ansaug- oder Lüftungsprozesses auch beim Eintauchen des inneren in den äußeren Teil in ihrer zur Halbleiterbearbeitungsmaschine abgewandten Seite Bohrungen auf.
Außerdem kann der innere Teil zum Vorteil der Gasströmung in seinem Boden Löcher besitzen.

Das Ankoppelelement kann vorteilhafterweise eine zur Halbleiterbearbeitungsmaschine justierbare Bodenplatte mit äbgeschrägter Vorderkante sein, in der sich zur formschlüssigen, koordinatengerechten Orientierung Kugelkalottenstützschrauben in Formelemente absetzen.

Zur Befestigung kann ein in seiner Kraft umschaltbarer Permanentmagnet am feststehenden Teil der Einhausung angebracht werden.

Mit einer derartigen Lösung erfindungsgemäßen fahrbaren Einrichtung ist eine Be-und Entladeeinrichtung koordinatengerecht gegenüber einer Halbleiterbearbeitungsmaschine justierbar einzurichten. Die Einrichtung ist mit der Be- und Entladeeinrichtung standsicher und weitestgehend zur Halbleiterbearbeitungsmaschine schwingungsmäßig entkoppelt anzubringen.
Zu Servicezwecken ist die Einrichtung in kürzester Zeit und in unkomplizierter Weise von der Halbleiterbearbeitungsmaschine entfernbar und kann reproduzierbar wieder angerückt werden.
Außerdem benötigt diese Lösung keine Justierpunkte bzw. Verriegelungseinrichtungen an der Halbleiterbearbeitungsmaschine
Eine Behinderung durch über die projezierte Fläche des Beschickungsroboter hinausragende Elemente ist ausgeschlossen, wodurch ein sehr enges Aneinanderrücken von zwei Einrichtungen gemäß der Erfindung nebeneinander und an die Halbleiterbearbeitungsmaschine gewährleistet ist.

Entsprechend der technologischen Prozesse müssen immer häufiger auch Magazine für Halbleiterscheiben eingesetzt werden, die vom Standard hinsichtlich Anschlußmaße, Maße, Waferkapazität oder Material abweichen.
Bei einer durchgehenden Ausrüstung einer Halbleiterfabrik mit dem SMIF-Standard können sich dadurch Einschränkungen oder Störungen im normal üblichen Produktionsablauf ergeben.

Deshalb wird eine vorteilhafte Ausgestaltung vorgeshen, bei der ein im Inneren der Be- und Entladeeinrichtung absenkbares Plattenteil neben einem Transportbehälter für ein Magazin als Beschickungsgegenstand auch das Magazin selbst als Beschickungsgegenstand aufnehmen kann.
Dazu wird mit dem Plattenteil ein Adapter verbunden, auf dem das Magazin absetzbar ist und der die Funktion des Bodens der SMIF-Box übernimmt.
Der Adapter weist auf einer Grundplatte mindestens eine Führung mit parallel zueinander gerichteten Führungskanten auf, zwischen die das Magazin mit einem Steg, der gegenüberliegende Magazinwände des Magazins verbindet, abgestellt wird. Ein Paar absenkbarer, durch die Grundplatte hindurchgeführter Elemente überträgt eine gleichzeitige Betätigung durch die Magazinwände im abgestellten Zustand des Magazins über Verbindungselemente auf Sensoren in dem Plattenteil.

Mit dieser Ausgestaltung können Magazine mit einer Be- und Entladeeinrichtung, die ausschließlich für die SMIF-Technologie ausgelegt ist, transportiert werden, da durch das mechanische Erkennungs- und Übertragungssystem aufgesetzte Magazine mit dem sich im Plattenteil (SMIF-Port) üblicherweise befindlichen Detektorsystem erkannt werden können.

Zur Sicherheit der Einrichtung kann der Lift für das Aufnahmeelement von einem Schrittmotor angetrieben werden, der mit einer spannungsabhängigen Motorbremse verbunden ist.
Desweiteren können Gasdruckfedern den Lift gegenüber dem feststehenden Teil abstützen.

Weiterhin kann der feststehende Teil einen beweglichen Sicherheitsbügel tragen, bei dem aufliegende Gegenstände eine Kontaktunterbrechung eines sonst geschlossenen Stromkreises erzeugen, wodurch der Schrittmotor abgeschaltet wird.

Die Erfindung soll nachstehend anhand der schematischen Zeichnung näher erläutert werden. Es zeigen:
- Fig. 1: eine Einrichtung im angekoppelten Zustand an eine Halbleiterbearbeitungsmaschine
- Fig. 2: die Einrichtung ohne Gehäuse
- Fig. 3: die Einrichtung in einer Einstellung zur ergonomischen Bestückung einer Be- und Entladeeinrichtung
- Fig. 4: die Einrichtung in einer Einstellung zur Beschickung einer Halbleiterbearbeitungsmaschine
- Fig. 5: eine Einrichtung mit erweitertem seitlichen Beschickungsbereich
- Fig. 6: die Einrichtung gemäß Fig. 5 in verkleidetem Zustand
- Fig. 7: eine Einrichtung für zwei unterschiedliche Beschickungshöhen
- Fig. 8: eine Einhausung für eine Beschickung von Halbleiterbearbeitungsmaschinen mit verschließbarer Beschickungsöffnung
- Fig. 9: eine Einhausung für eine Beschickung von Halbleiterbearbeitungsmaschinen ohne Verschluß der Beschickungsöffnung
- Fig. 10: eine Einhausung für eine zweietagige Beschickung von Halbleiterbearbeitungsmaschinen ohne Verschluß der Beschickungsöffnung
- Fig. 11: eine Einhausung für eine einetagige Beschickung von zwei oder mehrere nebeneinanderliegenden Beschickungs- oder Entnahmestationen ohne Verschluß der Beschicküngsöffnung
- Fig. 12: die Einrichtung auf einer Grundplatte justiert zur Halbleiterbearbeitungsmaschine abgestellt
- Fig. 13: Mittel zur Ausrichtung und standsicheren Befestigung der Einrichtung gegenüber der Halbleiterbearbeitungsmaschine
- Fig. 14: eine Aufsicht auf einen ersten Adapter für den separaten Einsatz eines Magazins ohne Transportbehälter in der Be- und Entladeeinrichtung
- Fig. 15: der erste Adapter im Querschnitt
- Fig. 16: eine Aufsicht auf einen zweiten Adapter
- Fig. 17: der zweite Adapter im Querschnitt

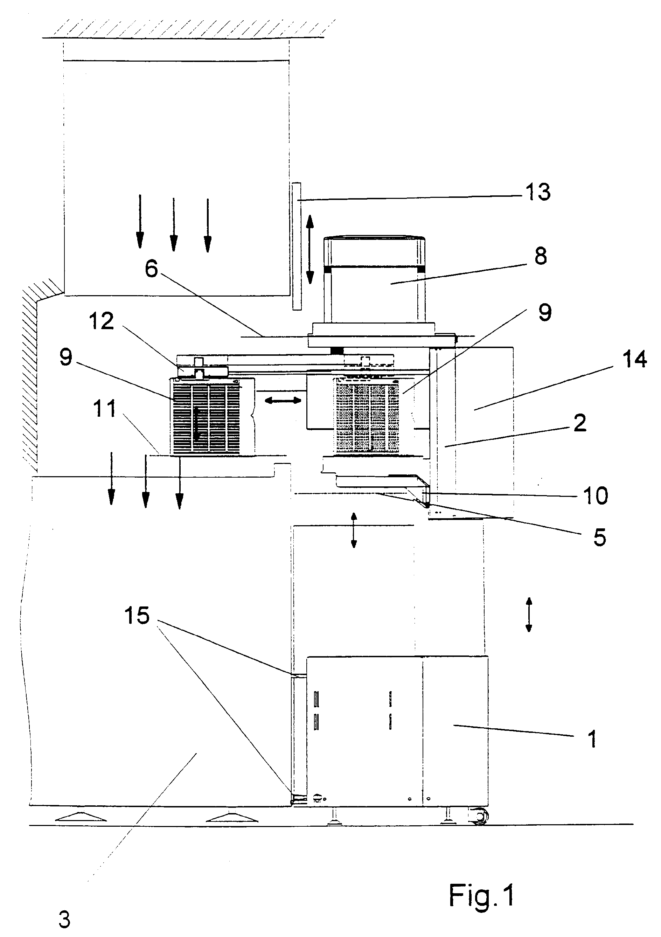

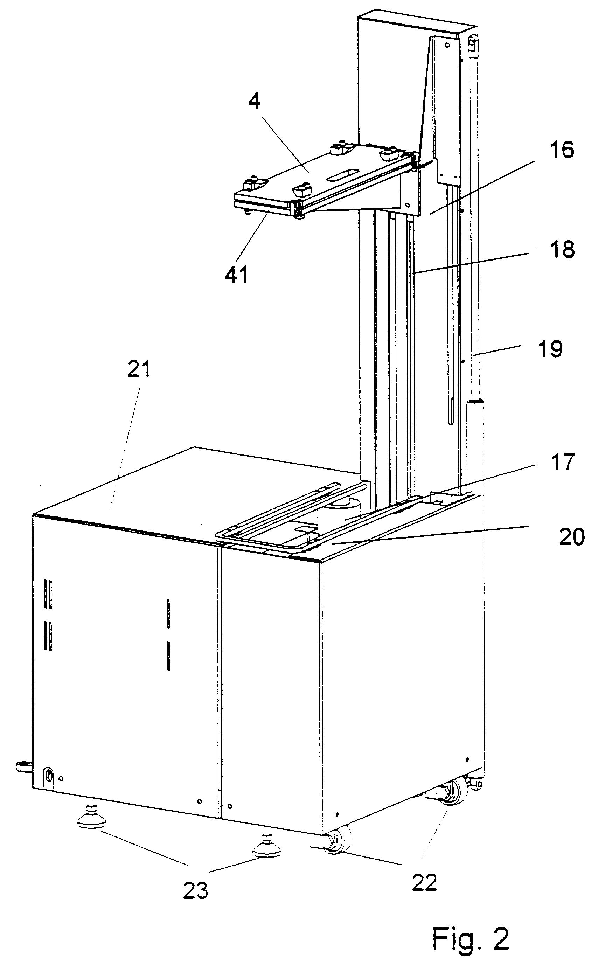

Eine in Fig. 1 dargestellte Einrichtung 1 trägt als Be- und Entladeeinrichtung 2 eine Transportvorrichtung gemäß DE-Patent 43 26 309 C1. Anstelle des Einsatzes dieser Vorrichtung ist es natürlich auch möglich, Einrichtungen mit anderem Furktionsablauf zur Be- und Entladung einer Halbleiterbearbeitungsmaschine 3 einzusetzen.
Als Aufnahmeelement für die Be- und Entladeeinrichtung 2 dient eine justierbare Grundplatte 4 (Fig. 2), die zwischen zwei übereinanderliegenden Ebenen 5, 6 verfahrbar ist. Die Ebene 5 liegt in einer ergonomisch günstigen Höhe zur Beschickung der Be- und Entladeeinrichtung 2, in der auf einem als Schnittstelle dienenden Plattenteil 7 ein Transportbehälter 8 in Form einer SMIF-Box als Beschickungsgegenstand abstellbar ist. In der Ebene 6, die als Beschickungsebene dient, erfolgt eine automatische Öffnung des SMIF-Pods und ein Magazin 9 wird mit einem Fahrstuhl 10 in eine Übergabehöhe 11 gefahren. Ein Greifer 12 erfaßt das Magazin 9 und transportiert es durch eine Linearbewegung in die Halbleiterbearbeitungsmaschine 3.

Entsprechend erfolgt die Entnahme des Magazins 9 aus der Halbleiterbearbeitungsmaschine 3 mit umgekehrter Schrittfolge.

Ein Verschlußelement 13, das gehäusegekoppelt ist, übernimmt das Öffnen und Schließen der Halbleiterbearbeitungsmaschine 3. Dabei wird sichergestellt, daß sowohl die Luftströmung innerhalb der Halbleiterbearbeitungsmaschine 3 ungestört bleibt als auch der Zugang für die Beschickung bzw. Entnahme des Magazines 9 gewährleistet ist.

In Abhängigkeit von der Luftströmung in der Halbleiterbearbeitungsmaschine 3 kann ein Luftstrom, der durch eine Filter-Lüfter-Einheit 14 erzeugt wird, in Richtung der Halbleiterbearbeitungsmaschine 3 wirken oder einen aus der Halbleiterbearbeitungsmaschine 3 gerichteten Luftstrom unterstützen.

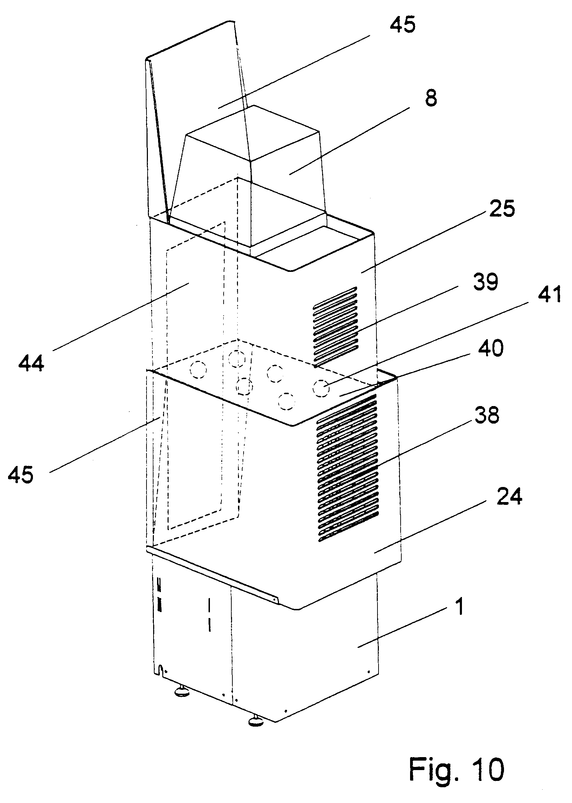

Die Kopplung der Einrichtung 1 mit der Halbleiterbearbeitungsmaschine 3 kann mit lösbaren Andockelementen 15 oder in einer gemäß einer Lösung entsprechend den Figuren 10 bis 13 erfolgen.

Gemäß Fig. 2 ist die justierbare Grundplatte 4, die auf einer Befestigungsplatte 41 aufgeschraubt ist, zum Verfahren zwischen den zwei übereinanderliegenden Ebenen 5, 6 auf einem in vertikaler Richtung beweglichen Lift 16, der durch einen Schrittmotor 17 elektromotorisch angetrieben wird, befestigt. Die Drehbewegung des Schrittmotors 17 wird über einen nicht dargestellten Zahnriemen auf eine Gewindespindel 18 übertragen und in eine Linearbewegung umgewandelt wird.

Zur Gewährleistung einer aktiven Sicherheit wirkt bei Stromausfall oder Havarieabschaltung über einen hier nicht dargestellten "Not-Aus"-Schalter eine direkt mit dem Schrittmotor 17 verbundene, spannungsunabhängige Motorbremse.
Zusätzlich wird die Masse der in vertikaler Richtung bewegten Bauteile durch zwei Gasdruckfedern 19, von denen eine sichtbar ist, kompensiert.

Ein ausgeführter Sicherheitsbügel 20 bildet eine weitere Maßnahine zur Erhöhung der Sicherheit, besonders zur Vermeidung von Verletzungen des Bedienpersonales. Ein zwischen den Lift 16 und den Sicherheitsbügel 20 gelangter Gegenstand hat bei Krafteinwirkung auf den Sicherheitsbügel 20 eine Kontaktunterbrechung eines sonst geschlossenen Stromkreises und damit das sofortige Abschalten des Schrittmotors 17 zur Folge. Der Lift 16 bleibt in der momentanen Position stehen und wird durch die Wirkung der Gesdruckfedern 19 gehalten.

Die Einrichtung 1 ist von einer Verkleidung 21 umgeben, die ein Gefäßsystem bildet, das unter anderem auch die hier nicht dargestellte Steuerelektronik aufnimmt.

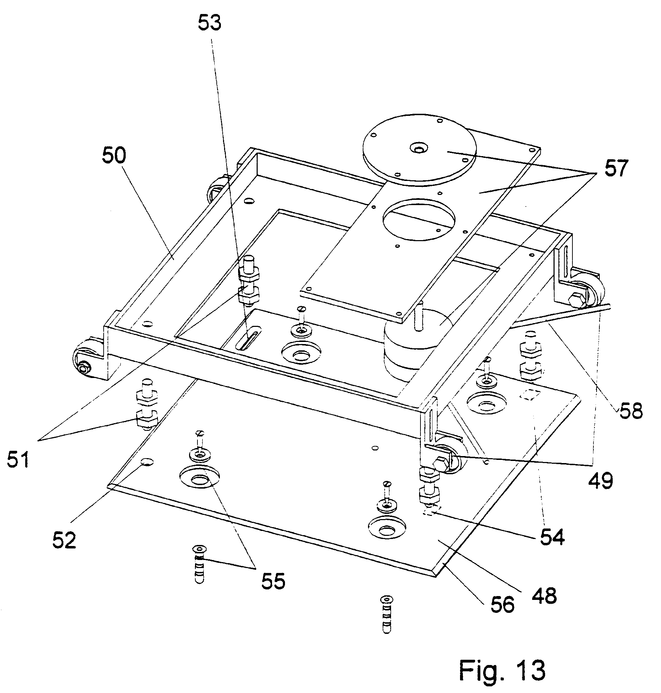

Mit Hilfe von Rollen 22 kann das gesamte Gerät leicht transportiert werden, eine Voraussetzung für schnelles An- und Abdocken an die Halbleiterbearbeitungsmaschine. Zum Abstellen dienen entweder justierbare Füße 23 oder es wird eine Lösung gemäß der Figuren 13 verwendet.

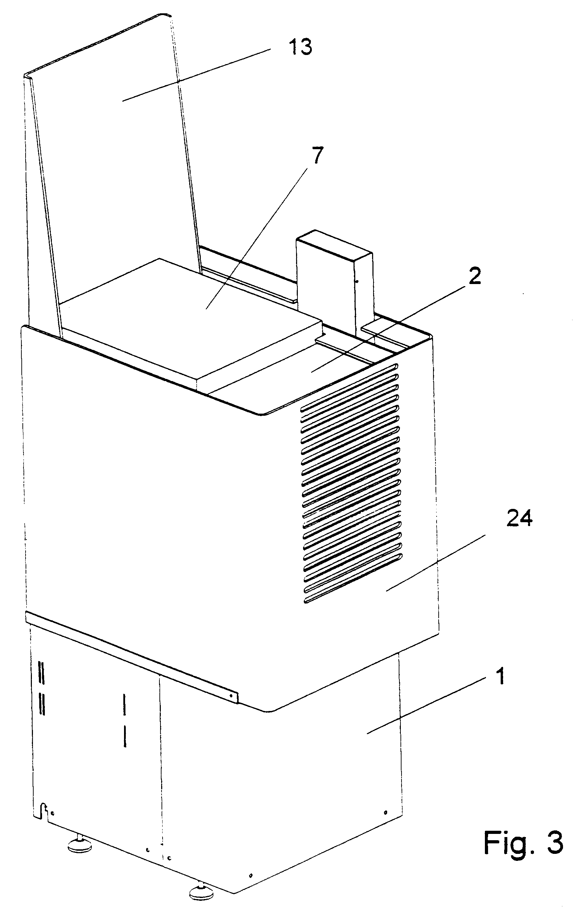

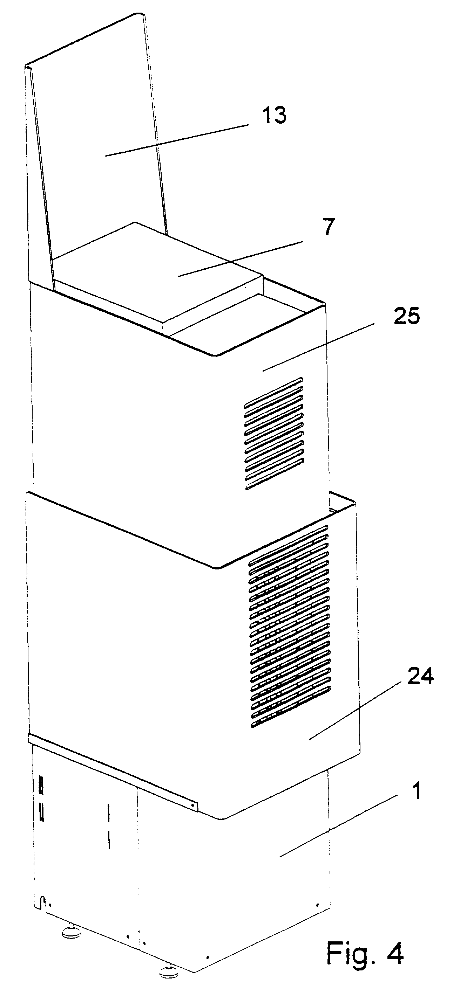

Im verkleideten Zustand gemäß Fig. 3, in der sich das Plattenteil 7 in der als Beschickungsebene dienenden Ebene 6 befindet, ist die gesamte Einrichtung eingehaust, so daß im Inneren Reinstraumbedingungen gewährleistet sind.
Wie Fig. 4 zeigt, besteht die Einhausung aus einem feststehenden äußeren Teil, dem Gehäuse 24 und einem inneren Teil, dem Gehäuse 25, das das Aufnahmeelement und die Be- und Entladeeinrichtung 2 umschließt und für die Beschickung der Halbleiterbearbeitungsmaschine 3 teleskopartig ausfahrbar ist. Durch eine derartige Gehäusegestaltung werden die erforderlichen Reinstraumbedingungen bei der Beschickung bzw. bei der Nachrüstung der Halbleiterbearbeitungsmaschine mit der SMIF-Technologie gewährleistet.

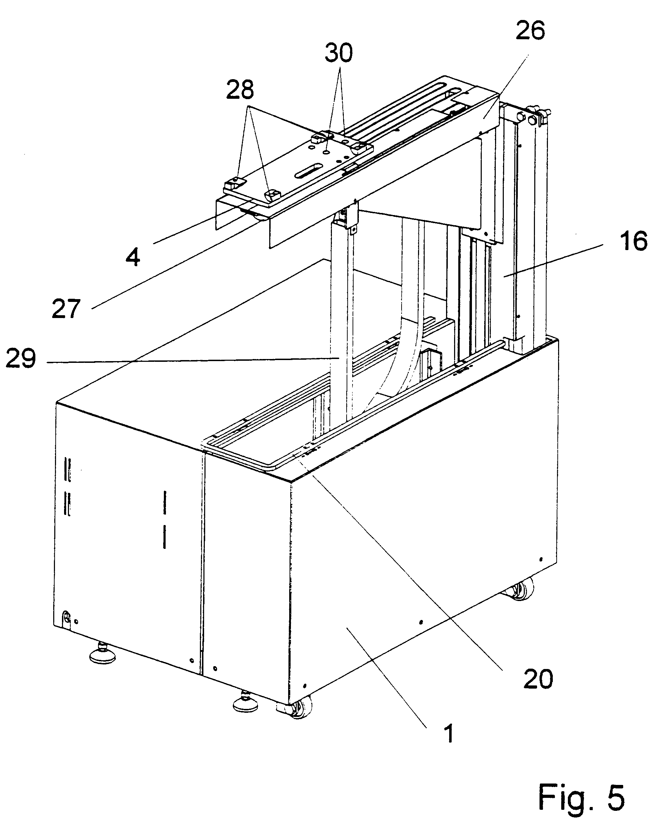

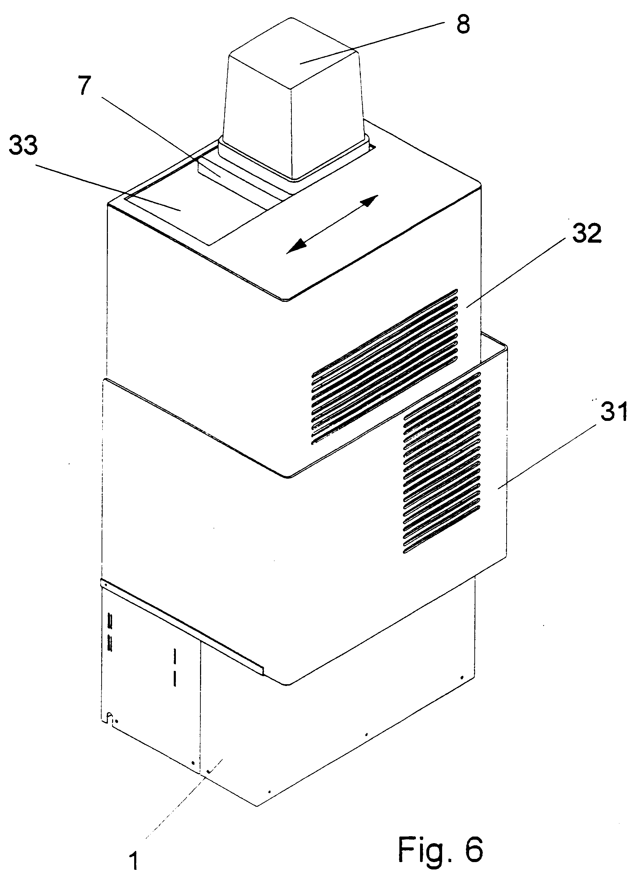

Zur Erweiterung des Bewegungsbereiches der Einrichtung 1 dient eine Lösung gemäß der Figuren 5 und 6, mit denen zusätzlich zu den übereinanderliegenden Ebenen 5, 6 auch nebeneinander liegende Bearbeitungsplätze bedient werden können.

Auf die in Fig. 2 dargestellte Befestigungsplatte 41 wird anstatt der justierbaren Grundplatte 4 zur Aufnahme der Be- und Entladeeinrichtung 2 eine Einheit 26 aufgesetzt, die in der Lage ist, eine lineare Bewegung in horizontaler Richtung auszuführen. Mittels entsprechender mechanischer Befestigungselemente (nicht dargestellt) wird die justierbare Grundplatte 4 auf dieser Einheit 26 befestigt.

Die Einheit 26 besteht aus einem u-förmigen Grundkörper als Aufnahme für einen Schrittmotor 27 mit nicht dargestelltem Spindelantrieb und damit gekoppelter Führung. Der Schrittmotor 27 wird über einen Encoder schrittüberwacht und durch elektronische Endlagenkoppler in beiden Endlagen überwacht.
Zur Verbindung der aufzusetzenden, mit Befestigungselementen 28 zu haltenden Be- und Entladeeinrichtung 2 mit der elektronischen Steuerung dient ein geführtes Schleppkabel 29.
Entsprechend der mechanischen Ausbildung der justierbaren Grundplatte 4 mit einer Wiederfindeinrichtung 30 ist ein schneller Wechsel der Be- und Entladeeinrichtung 2 möglich.

Bei der Darstellung in Fig. 6 ist die Lösung gemäß Fig. 5 von Gehäusen 31, 32 umschlossen, was prinzipiell der Einhausung nach Fig. 4 entspricht. Zur Höhenverstellung wird das Gehäuse 32 zum Gehäuse 31 teleskopartig verfahren.
Durch ein bewegliches Verschlußelemente 33 wie z.B. einer Tür, einer Schiebeklappe oder ein rolloähnlicher Verschluß, wird gesichert, daß der innere Reinraum der Be- und Entladeeinrichtung 2 auch während der seitlichen Bewegung verschlossen bleibt.

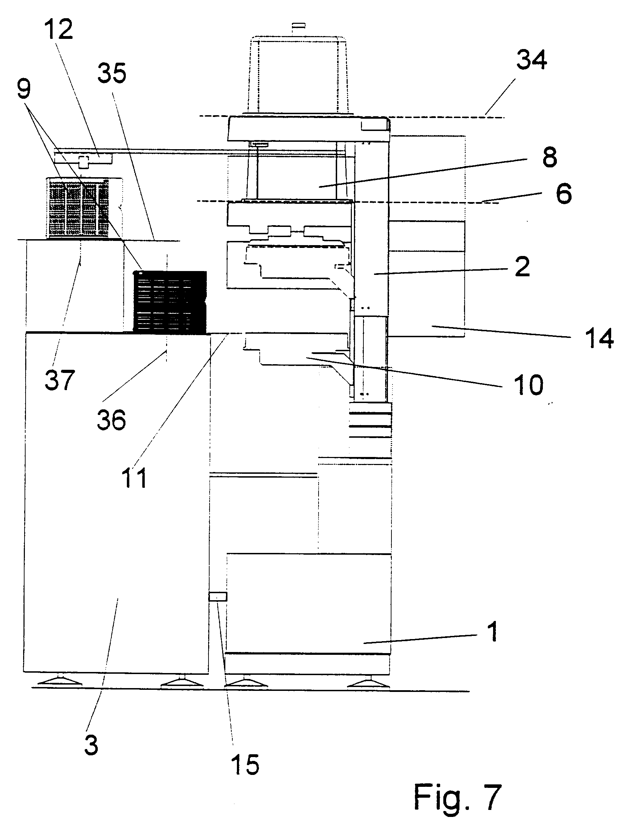

Mit der erfindungsgemäßen Lösung ist es außerdem möglich, neben den in Fig. 1 dargestellten übereinanderliegenden Ebenen 5, 6 weitere Ebenen durch eine Höhenverstellung der zur Aufnahme dienenden Platte 4 anzufahren.
Ein Beispiel wird in Fig. 7 gezeigt, in dem zusätzlich in einer Ebene 34 eine Beschickung der Halbleiterbearbeitungsmaschine 3 durchgeführt werden kann.
Das Magazin 9 ist von der Ebene 6 in einer Übergabehöhe 11 und von der Ebene 34 in einer weiteren Übergabehöhe 35 in die Halbleiterbearbeitungsmaschine 3 transportierbar.
Außerdem ist es mit der Be- und Entladeeinrichtung 2 möglich, von den Ebenen 6 und 34 aus das Magazin 9 in verschiedenen Positionen 36, 37 oder beim Einsatz von Einrichtungen mit anders gestaltetem Funktionsablauf als bei der Transportvorrichtung gemäß dem DE-Patent 43 26 309 C1 in anderen Lagen abzustellen.

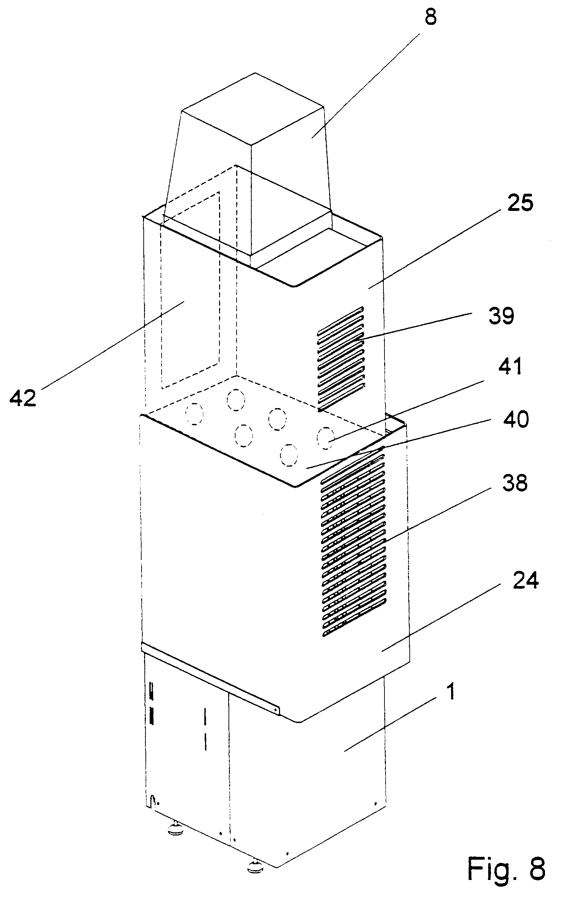

Anhand der Figuren 8 bis 11 wird die Einhausung für Be- und Entladegeräte 2 näher beschrieben, die eine in ihrer zur Halbleiterbearbeitungsmaschine 3 abgewandten Rückwand integrierte Filter-Gebläse/Lüfter-Einheit 14 besitzen, und die, wie bereits beschrieben, über eine justierbare Grundplatte 4 mechanisch fest verbunden, zur Halbleiterbearbeitungsmaschine 3 höhenverstellbar und/oder querverschiebbar sind.

Die in Fig. 8 dargestellte Einhausung besteht, wie schon aus Fig. 4 bekannt, aus dem feststehenden Gehäuse 24, in dem das höhenverstellbare Gehäuse 25 der Be-und Entladeeinrichtung integriert ist. Das Gehäuse 25 wird vorzugsweise durch vier antistatische und damit reinraumgerechte Kunststoffplatten gebildet, die fest an beiden Seitenwänden und der Ober- und Unterseite der Be- und Entladeeinrichtung 2 montiert sind.
Eine derartige Einhausung ist zur einetagigen Beschickung von Halbleiterbearbeitungsmaschinen mit selbstverschließbarer Beschickungsöffnung geeignet.

Beide Gehäuse 24, 25 sind an ihrer, der Halbleiterbearbeitungsmaschine 3 zugewandten Vorderseite vollständig offen. Durch die anhand der Figuren noch näher zu beschreibende Wiederfindeinrichtung ist ein Abstand aller senkrecht zur Halbleiterbearbeitungsmaschine 3 benachbarten Wandteile so herzustellen, daß eine mechanische Berührung bei der Höhenverschiebung ausgeschlossen ist, die Reinraumbedingungen jedoch ungestört bleiben.
Beide Gehäuse weisen in ihren Rückwänden Bohrungen 38, 39 zur Gewährleistung des Ansaug- oder Lüftungsprozesses auch beim Eintauchen des höhenverschiebbaren Gehäuses 25 in das feststehende Gehäuse 24.
Das Gehäuse 25 ist nach unten durch eine Bodenplatte 40 abgeschlossen, in die Löcher 41 eingearbeitet sind um einerseits eine senkrechte Strömung mit Drosselwirkung/Düsenwirkung entlang der Vorderseite der Halbleiterbearbeitungsmaschine 3 beim Eintauchen/Herausfahren des höhenverschiebbaren Gehäuses 25 in das feststehende Gehäuse 24 gering zu halten und andererseits einen Überdruck oder ein Druckgefälle in dem gebildeten Mini-Reinstraum gegenüber der Umgebung bzw. der Halbleiterbearbeitungsmaschine 3 zu gewährleisten.
Außerdem sind nicht dargestellte Mittel vorgesehen für das selbständige Aus-bzw. Einschalten der Filter-Gebläse/Lüfter-Einheit 14 beim Fahren in bzw. aus der Ebene 5, in der die Be- und Entladeeinrichtung 2 mit einer SMIF-Box beschickt wird.

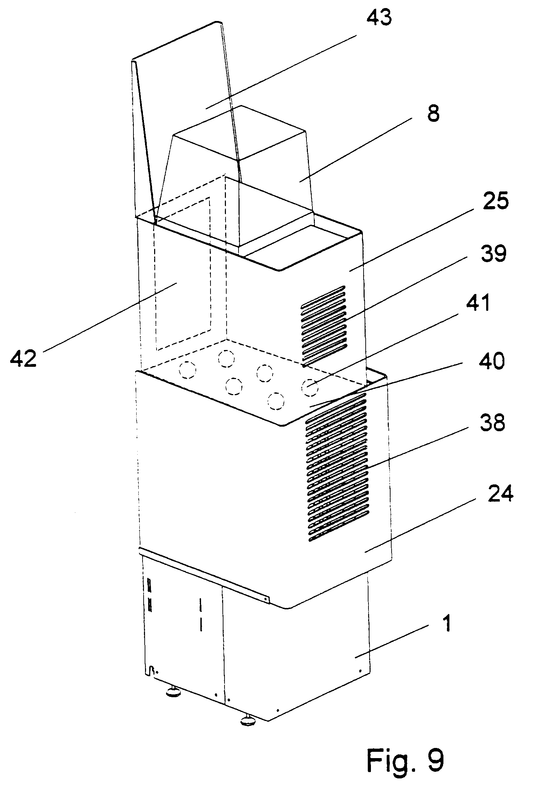

Für eine einetagige Beschicküng von Halbleiterbearbeitungsmaschinen 3, die keinen Verschluß für eine Beschicküngsöffnung 42 aufweisen, ist nach Fig. 9 zusätzlich ein parallel zur Vorderwand der Halbleiterbearbeitungsmaschine 3 verlaufender Schild 43 vorgesehen, der beim Fahren der Be- und Entladeeinrichtung 2 in die Ebene 5 die Beschickungsöffnung 42 verschließt.

Für eine zweietagige Beschickung von Halbleiterbearbeitungsmaschinen, die keinen Verschluß für eine Beschickungsöffnung 44 aufweisen, sind in Fig. 10 zusätzlich zur Lösung gemäß Fig. 9 zwei Schilde 45 parallel zur Vorderwand der Halbleiterbearbeitungsmaschine 3 mit dem Gehäuse 25 fest verbunden. Die Ausführung dient der Beschickung einer parallel zur Vorderwand der Halbleiterbearbeitungsmaschine 3 in zwei übereinanderliegenden Ebenen, wie in Fig. 7 dargestellt.
Die Schilde 45 sind so gestaltet, daß immer der nicht beschickte Teil der Öffnung 44 der Halbleiterbearbeitungsmaschine verschlossen wird.

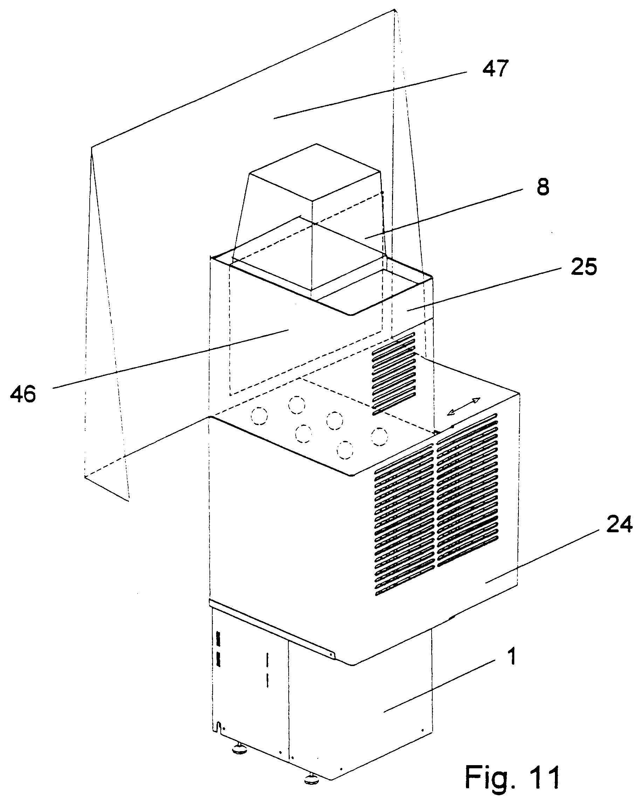

Schließlich ist für eine einetagige Beschickung in zwei oder mehrere nebeneinanderliegende Beschickungs- oder Entnahmestationen in einer Halbleiterbearbeitungsmaschine 3, die keinen Verschluß für eine Beschickungsöffnung 46 aufweist, nach Fig. 11 ein Schild 47 fest am Gehäuse 25 und parallel zur Vorderwand der Halbleiterbearbeitungsmaschine 3 befestigt, das beim Fahren der Be- und Entladeeinrichtung 2 in die Ebene 5 immer den nicht beschickten Teil der Beschickungsöffnung 46 verschließt.

Anstelle der fest mit der Be- und Entladeeinrichtung 2 verbundenen Schilde zum Verschließen der Beschickungsöffnungen könne auch bewegliche Abdeckungen, wie etwa reinraumgerechte Rollos verwendet werden.
Es sind auch Lösungen verwendbar, die mit der Bewegung der Be- und Entladegeräte gekoppelte Schiebetüren der Halbleiterbearbeitungsmaschine vorsehen.

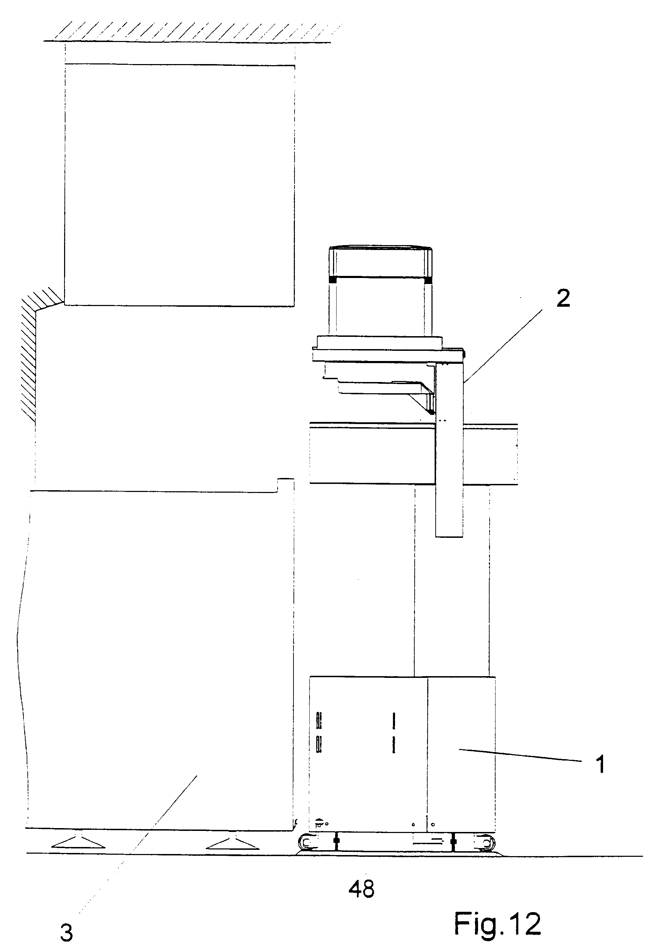

Nach Fig. 12 wird vor der Halbleiterbearbeitungsmaschine 3 eine zur Halbleiterbearbeitungsmaschine 3 justierte, als Ankoppelelement dienende flache Bodenplatte 48 zur Aufnahme der Einrichtung 1 mit der Be- und Entladeeinrichtung 2 mit dem Fußboden verschraubt.
In der Bodenplatte 48 befinden sich für ein reproduzierbares formschlüssiges Wiederfinden der justierten Lage für die Einrichtung 1 geeignete Elemente.

Die Einrichtung 1 kann zusammen mit der Be- und Entladeeinrichtung 2 in angekipptem Zustand auf Rollen 49 sackkarrenartig weg- bzw. herangefahren werden.

Entsprechend Fig. 13 sind zum Andocken in einem Grundrahmen 50 im Bereich des Bodens der Einrichtung 1 in vertikaler Richtung justierbare Kugelkalottenstützschrauben 51. Diese setzen sich zur formschlüssigen koordinatengerechten Orientierung in die in der Bodenplatte 48 befindlichen Elemente Kegel 52, Prisma 53 und Ebene 54 ab.
Über Schrauben 55 ist die Bodenplatte 48 wiederum koordinatengerecht zur Halbleiterbearbeitungsmaschine 3 mit dem Fußboden fest verschraubt.
Die Vorderkante 56 der Bodenplatte 48 ist so gestaltet, daß diese zur Vororientierung (Voranschlag) für die Auffahrt der Rollen 49 dient und von dieser Stelle aus das Absenken der Einrichtung nach der sackkarrengemäßen Anfahrt erfolgt.
Die Stützschrauben 51 finden die Formelemente 52, 53 und 54 der Bodenplatte 48 selbst.

Die statische Sicherheit der Einrichtung 1 wird vorzugsweise durch einen kardanisch am Grundrahmen 50 befestigten stellbaren Permanentmagneten 57 erzielt. In der Arbeitsstellung der Einrichtung 1 wird der Permanentmagnet 57 auf höchste Haltekraft von außen über einen Stellhebel 58 geschaltet. Damit ist eine kraftschlüssige Verbindung mit der Bodenplatte 48 gewährleistet verbunden mit einer hohen Standsicherheit.

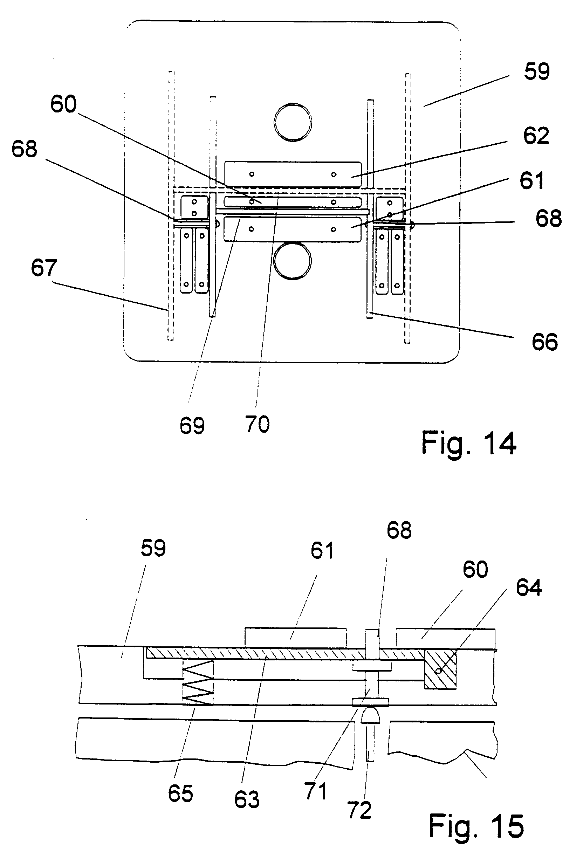

Die in den Figuren 14 bis 17 dargestellten Adapter sind geeignet, je nachdem welche Halbleiterscheibenmaße verwendet werden sollen, auf dem Plattenteil 7 befestigt zu werden, und als Beschickungsgegenstand direkt ein Magazin 9 aufzunehmen.

Gemäß den Figuren 14 und 15 befinden sich auf einer Grundplatte 59 , die den Maßen des Plattenteils 7 in Länge, Breite und Höhe entspricht, benachbart zu einer Führungsschiene 60 eine Anlageschiene 61 für 4"-Magazine und eine Anlageschiene 62 für 6"-Magazine.
Ein unterhalb der Grundplatte 59 angeordneter Winkel 63, der über ein einseitiges Gelenk 64 gelagert und durch eine Feder 65 abgestützt ist, wird von seitlichen Magarinwänden 66 oder 67 von abgesetzten Magazinen über ein durch die Grundplatte 59 hindurchgeführtes absenkbares Element 68 betätigt. Die Magazinwand 66 ist einem Magazin kleinerer Größe (4") und die Magazinwand 67 einem Magazin größerer Abmessungen (6") zugeordnet. Bei beiden Magazinen sind die Magazinwände 66, 67, dem SEMI-Standard entsprechend, durch Verbindungsstege 69, 70, einem sogenannten H-bar miteinander verbunden. Die Verbindungsstege 69, 70 sind die Elemente der Magazine, die zur Fixierung auf der Grundplatte 59 dienen.
Durch die Betätigung des Winkels 63 erfolgt in dem Plattenteil 7 über einen Amboß 71 eine Betätigung von Sensoren 72, die auch als Schalter ausgebildet sein können. Die Sensoren 72 haben neben anderen Aufgaben die Funktion, den aufgesetzten Zustand zu signalisieren. Die Anordnung derartiger Sensoren ist
z. B. in der Patentschritt DE 43 26 308 C1 mit der dortigen weiteren Funktion der Einleitung einer Gaszufuhr und -ableitung dargestellt.
Die Feder 65 verhindert, daß im unbelasteten Zustand die Sensoren 72 im Plattenteil 7 betätigt werden. Die Feder 65 ist so bemessen, daß ein volles oder leeres Magazin die Sensoren 72 sicher betätigt. Für die sichere Erkennung des abgesetzten Zustandes ist ebenfalls die gleichzeitige Betätigung beider Auflageflächen 68 erforderlich.

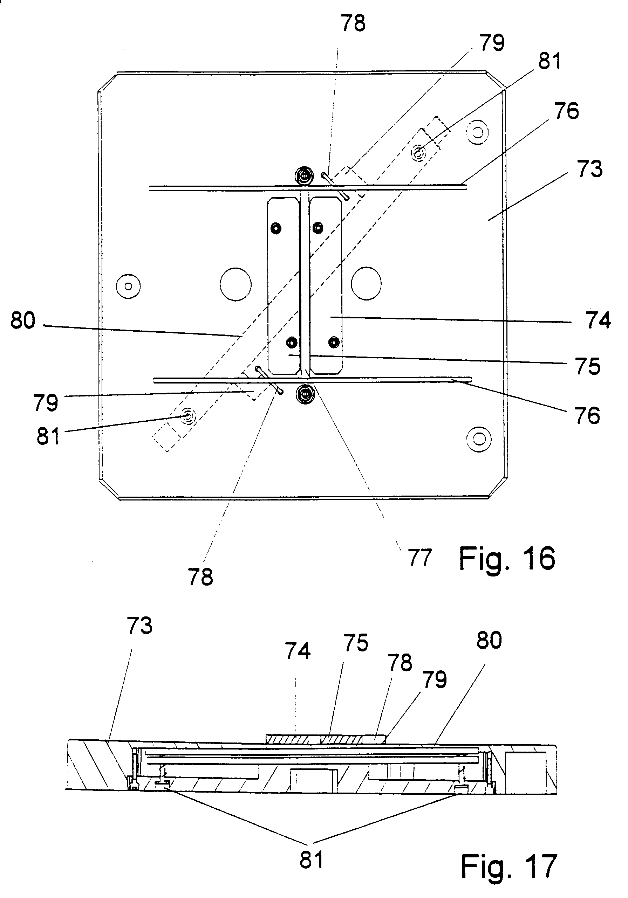

Für Magazine mit noch größerer Abmessungen (8") ist eine Ausführung des Adapters gemäß den Figuren 16 und 17 vorgesehen.
Auf einer Grundplatte 73 sind eine Führungsschienen 74 und eine Anlageschiene 75 angeordnet. Ein mit seinem, Seitenwände 76 verbindenden Steg 77 zwischen die Führungsschiene 74 und die Anlageschiene 75 abgestelltes Magazin betätigt mit den Magazinwänden 76 gleichzeitig durch die Grundplatte 73 hindurchgeführte, absenkbare Elemente 78. Der Übersicht halber ist das Magazin ebenso wie in Fig. 14 nicht vollständig dargestellt. Die Auflageflächen 78 sind über Stege 79 mit einer beweglichen Leiste 80 verbunden, so daß an der Leiste 80 federnd befestigte Betätigungsstifte 81 die in dem Plattenteil 7 vorgesehenen Sensoren drücken können.

## Patentansprüche

1. Einrichtung zur Kopplung einer Be- und Entladeeinrichtung (2) mit einer Halbleiterbearbeitungsmaschine (3), mit einer fahrbaren Einhausung, innerhalb derer ein justierbares Aufnahmeelement (4) für die Be- und Entladeeinrichtung (2) vorgesehen ist, das zwischen mindestens zwei übereinanderliegenden Ebenen (5,6) verstellbar ist, von denen eine (5) der Bestückung der Be- und Entladeeinrichtung (2) und jede andere (6) zur Beschickung der Halbleiterbearbeitungsmaschine (3) durch die Be- und Entladeeinrichtung (2) dient, **dadurch gekennzeichnet**, daß die Einhausung Ausricht- und Halteelemente (49,50,51,57) zur Befestigung an einem zur Halbleiterbearbeitungsmaschine (3) ausgerichteten Ankoppelelement (48,52-56) aufweist und aus einem feststehenden äußeren Teil (24) sowie einem aus diesem teleskopartig ausfahrbaren und zwischen den übereinanderliegenden Ebenen (5,6) verfahrbaren inneren Teil (25) besteht, welches das Aufnahmeelement zusammen mit der Be- und Entladeeinrichtung (2) umschließt, wobei jeweils auf der von der Halbleiterbearbeitungsmaschine (3) abgewandten Rückwand die Be- und Entladeeinrichtung (2) mit einer ein Filter und ein Gebläse umfassenden Einheit (14) und das äußere (24) wie auch das innere (25) Teil der Einhausung jeweils in seiner von der Halbleiterbearbeitungsmaschine abgewandten Seite mit Bohrungen (38,39) versehen ist.

2. Einrichtung nach Anspruch 1, dadurch gekennzeichnet, daß das Aufnahmeelement eine mit einem Lift (16) verbundene justierbare Platte (4) ist.

3. Einrichtung nach Anspruch 1, dadurch gekennzeichnet, daß das Aufnahmeelement eine von einem horizontal beweglichen, auf einem Lift (16) befestigten Element (26) getragene justierbare Platte (4) ist.

4. Einrichtung nach einem der Ansprüche 1 bis 3, dadurch gekennzeichnet, daß am ausfahrbaren inneren Teil der Einhausung mindestens ein Verschlußelement (13,43,45,47) vorgesehen ist zum Verschließen von Beschickungsöffnungen (42,44,46) in der Halbleiterbearbeitungsmaschine (3).

5. Einrichtung nach Anspruch 4, dadurch gekennzeichnet, daß das innere Teil in seinem Boden (40) Löcher (41) besitzt.

6. Einrichtung nach einem der Ansprüche 1 bis 5, dadurch gekennzeichnet, daß das Ankoppelelement eine zur Halbleiterbearbeitungsmaschine (3) justierbare Bodenplatte (48) mit abgeschrägter Vorderkante (56) ist, in der sich zur formschlüssigen, koordinatengerechten Orientierung Kugelkalottenstützschrauben (51) in Formelemente (52,53,54) absetzen.

7. Einrichtung nach Anspruch 6, dadurch gekennzeichnet, daß zur Befestigung ein in seiner Kraft umschaltbarer Permanentmagnet (57) am feststehenden Teil der Einhausung angebracht ist.

8. Einrichtung nach einem der Ansprüche 1 bis 7, dadurch gekennzeichnet, daß die Be- und Entladeeinrichtung ein in ihr Inneres absenkbares Plattenteil (7) zur Aufnahme eines Beschickungsgegenstandes aufweist.

9. Einrichtung nach Anspruch 8, dadurch gekennzeichnet, daß auf dem Plattenteil (7) ein Adapter befestigt ist, auf den ein Magazin als Beschickungsgegenstand absetzbar ist.

10. Einrichtung nach Anspruch 9, dadurch gekennzeichnet, daß der Adapter auf einer Grundplatte (59) mindestens eine Führung mit parallel zueinander gerichteten Führungskanten aufweist, zwischen die ein Steg eines Beschickungsmagazins (9), der gegenüberliegende Magazinwände (66,67,76) des Beschickungsmagazins (9) verbindet, abstellbar ist, und daß ein Paar absenkbarer, durch die Grundplatte (59) hindurchgeführter Elemente (68,69) eine gleichzeitige Betätigung durch die Magazinwände (66,67,76) im abgestellten Zustand des Beschickungsmagazins (9) über Verbindungselemente auf Sensoren (72) in dem Plattenteil (7) überträgt.

11. Einrichtung nach einem der Ansprüche 2 bis 10, dadurch gekennzeichnet, daß der Lift (16) von einem Schrittmotor angetrieben ist, mit dem eine spannungsabhängige Motorbremse verbunden ist.

12. Einrichtung nach einem der Ansprüche 2 bis 11, dadurch gekennzeichnet, daß der Lift l(16) durch Gasdruckfedern (19) gegenüber dem feststehenden Teil abgestützt ist.

13. Einrichtung nach Anspruch 11 oder 12, dadurch gekennzeichnet, daß das feststehende Teil einen beweglichen Sicherheitsbügel (20) trägt, bei dem aufliegende Gegenstände eine Kontaktunterbrechung eines sonst geschlossenen Stromkreises erzeugen, wodurch der Schrittmotor (17) abgeschaltet wird.

## Claims

1. Device for coupling a loading and unloading apparatus (2) to a semiconductor processing machine (3) including a movable housing, within which an adjustable receiving element (4) is provided for the loading and unloading apparatus (2), which is movable between at least two superposed planes (5, 6), one (5) of which serves to charge the loading and unloading apparatus (2) and each other (6) of which serves to load the semiconductor processing machine (3) by means of the loading and unloading apparatus (2), characterised in that the housing has aligning and retaining elements (49, 50, 51, 57) for securing to a coupling element (48, 52-56) aligned with the semiconductor processing machine (3) and comprises a fixed outer portion (24) and a movable inner portion (25), which is extendable telescopically out of the latter and is movable between the superposed planes (5, 6), and which encloses the receiving element together with the loading and unloading apparatus (2), whereby the loading and unloading apparatus (2) is provided on the rear wall remote from the semiconductor processing machine (3) with a unit (14) including a filter and a fan and the outer (24) and the inner (25) portion of the housing is provided with bores (38, 39) in its surface remote from the semiconductor processing machine.

2. Device as claimed in Claim 1, characterised in that the receiving element is an adjustable plate (4) connected to a lift (16).

3. Device as claimed in Claim 1, characterised in that the receiving element is an adjustable plate carried by an element (26) which is horizontally movable and secured on a lift (16).

4. Device as claimed in one of Claims 1 to 3, characterised in that at least one closure element (13, 43, 45, 47) is provided on the extendable inner portion of the housing for closing loading openings (42, 44, 46) in the semiconductor processing machine (3).

5. Device as claimed in Claim 4, characterised in that the inner portion has holes (41) in its base (40).

6. Device as claimed in one of Claims 1 to 5, characterised in that the coupling element is a base plate (48), which is adjustable with respect to the semiconductor processing machine (3), with a bevelled front edge (56), in which spherical segment support screws (51) stand out in shaped elements (52, 53, 54) for a form-locking positionally correct orientation.

7. Device as claimed in Claim 6, characterised in that for fastening purposes a permanent magnet (57), whose force may be reversed, is mounted an the fixed portion of the housing.

8. Device as claimed in one of Claims 1 to 7, characterised in that the loading and unloading apparatus has a plate portion (7), which may be lowered in its interior, for receiving a loading article.

9. Device as claimed in Claim 8, characterised in that secured to the plate portion (7) there is an adapter on which a magazine constituting a loading article may be deposited.

10. Device as claimed in Claim 9, characterised in that the adapter has on a base plate (59) at least one guide with guide edges aligned parallel to one another, between which a web of a loading magazine (9), which connects opposing magazine walls (66, 67, 76) of the loading magazine (9), may be put down and that a pair of lowerable elements (68, 69), which pass through the base plate (59) transmits a simultaneous actuation through the magazine walls (66, 67, 76) in the put down state of the loading magazine (9) to sensors (72) in the plate portion (7) by means of connecting elements.

11. Device as claimed in one of Claims 2 to 10, characterised in that the lift (16) is driven by a stepper motor which is connected to a voltage-dependent motor brake.

12. Device as claimed in one of Claims 2 to 11, characterised in that the lift (16) is supported with respect to the fixed portion by means of gas pressure springs (19).

13. Device as claimed in Claim 11 or 12, characterised in that the fixed portion carries a movable safety bracket (20) with which articles resting on it produce a contact interruption of a current circuit which is otherwise closed, whereby the stepper motor (17) is switched off.

## Revendications

1. Dispositif d'accouplement d'un dispositif de chargement et de déchargement (2) à une machine (3) d'usinage de semi-conducteurs, comportant un boîtier déplaçable à l'intérieur duquel est prévu un élément de réception (4) ajustable pour le dispositif de chargement et de déchargement (2) et qui est déplaçable entre au moins deux plans (5, 6) superposés dont un (5) sert à équiper le dispositif de chargement et de déchargement (2) et chaque autre plan (6) sert à charger la machine (3) d'usinage de semi-conducteurs au moyen du dispositif de chargement et de déchargement (2), caractérisé en ce que le boîtier comporte des éléments d'orientation et de maintien (49, 50, 51, 55) pour la fixation à un élément d'accouplement (48, 52-56) orienté vers la machine (3) d'usinage de semi-conducteurs et en ce qu'il est constitué d'une partie extérieure (24) fixe ainsi que d'une partie intérieure (25) qui peut être extraite de la première de manière télescopique et qui peut être déplacée entre les plans (5, 6) superposés, et qui enferme l'élément de réception avec le dispositif de chargement et de déchargement (2), le dispositif de chargement et de déchargement (2) étant doté, sur la paroi arrière tournée à l'opposé de la machine (3) d'usinage de semi-conducteurs, d'une unité (14) comprenant un filtre et un ventilateur et la partie extérieure (24) étant pourvue, comme la partie intérieure (25) du boîtier, de perçages (38, 39) dans son côté tourné à l'opposé de la machine d'usinage de semi-conducteurs.

2. Dispositif selon la revendication 1, caractérisé en ce que l'élément de réception est une plaque (4) ajustable, reliée à un élévateur (16).

3. Dispositif selon la revendication 1, caractérisé en ce que l'élément de réception est une plaque (4) ajustable, supportée par un élément (26) déplaçable horizontalement et fixé sur un élévateur (16).

4. Dispositif selon l'une des revendications 1 à 3, caractérisé en ce qu'au moins un élément de fermeture (13, 43, 45, 47) est prévu sur la partie intérieure extractible du boîtier, pour fermer des ouvertures de chargement (42, 44, 46) de la machine (3) d'usinage de semi-conducteurs.

5. Dispositif selon la revendication 4, caractérisé en ce que la partie intérieure présente des trous (41) dans son fond (40).

6. Dispositif selon l'une des revendications 1 à 5, caractérisé en ce que l'élément d'accouplement est une plaque de fond (48) avec bords avant (56) chanfreinés et ajustables par rapport à la machine (3) d'usinage de semi-conducteurs, dans laquelle des vis d'appui (51) à tête sphérique se placent dans des éléments profilés (52, 53, 54), pour l'orientation correcte, par complémentarité de forme, par rapport aux coordonnées.

7. Dispositif selon la revendication 6, caractérisé en ce qu'un aimant permanent (57), de force commutable, est monté sur la partie fixe du boîtier, en vue de la fixation.

8. Dispositif selon l'une des revendications 1 à 7, caractérisé en ce que le dispositif de chargement et de déchargement comporte un élément en plaque (7) abaissable à l'intérieur de ce dispositif, destiné à recevoir un objet de chargement.

9. Dispositif selon la revendication 8, caractérisé en ce que sur l'élément en plaque (7) est fixé un adaptateur sur lequel peut être déposé un magasin servant d'objet de chargement.

10. Dispositif selon la revendication 9, caractérisé en ce que l'adaptateur présente, sur une plaque de base (59), au moins un organe de guidage à bords de guidage orientés parallèlement entre eux, entre lesquels peut-être adaptée une entretoise d'un magasin de chargement (9), qui relie des parois (66, 67, 76) opposées du magasin de chargement (9), et en ce qu'une paire d'éléments (68, 69) abaissables, guidés à travers la plaque de base (59), transmet un actionnement simultané à travers les parois (66, 67, 76) du magasin, à l'état mis en place du magasin de chargement (9), par l'intermédiaire d'éléments de liaison, à des capteurs (72) de l'élément en plaque (7).

11. Dispositif selon l'une des revendications 2 à 10, caractérisé en ce que l'élévateur (16) est entraîné par un moteur pas à pas, auquel est relié un frein moteur dépendant de la tension.

12. Dispositif selon l'une des revendications 2 à 11, caractérisé en ce que l'élévateur (16) est soutenu par des ressorts (19) à pression de gaz par rapport à la partie fixe.

13. Dispositif selon la revendication 11 ou 12, caractérisé en ce que la partie fixe supporte un étrier de sûreté (20) mobile par lequel des objets chargés produisent une interruption du contact dans un circuit électrique par ailleurs fermé, ce qui a pour effet de mettre à l'arrêt le moteur pas à pas (17).
